# EUROPÄISCHE PATENTSCHRIFT

(11) **EP 2 777 373 B1**
(45) Veröffentlichungstag und Bekanntmachung des Hinweises auf die Patenterteilung: **15.03.2017**
(21) Anmeldenummer: 12783988.4
(22) Anmeldetag: 07.11.2012
(51) Int. Cl.: H05K 7/14, H01R 9/26

(54) **FREQUENZUMRICHTER UND FEDERELEMENT HIERFÜR**
FREQUENCY CONVERTER AND SPRING ELEMENT THEREFOR
CONVERTISSEUR DE FRÉQUENCE ET ÉLÉMENT ÉLASTIQUE ASSOCIÉ

(30) Priorität: 07.11.2011 DE 102011085872
(43) Veröffentlichungstag der Anmeldung: 17.09.2014
(73) Patentinhaber: Lenze Automation GmbH, 31855 Aerzen (DE)
(72) Erfinder: NEUMANN, Edmund, 31789 Hameln (DE); BEILFUß-SPICKMANN, Uwe, 31840 Hessisch Oldendorf (DE); WEMPE, Andreas, 31855 Groß Berkel (DE); OLTMANN, Frank, 26169 Altenoythe (DE)
(74) Vertreter: Patentanwälte Ruff, Wilhelm, Beier, Dauster & Partner mbB
(86) Internationale Anmeldenummer: PCT/EP2012/072015
(87) Internationale Veröffentlichungsnummer: WO 2013/068391

(56) Entgegenhaltungen:
- WO-A1-93/13587
- DE-A1- 4 023 914
- DE-A1- 10 230 393
- US-A1- 2011 164 350

## Beschreibung

### Anwendungsgebiet und Stand der Technik

Die Erfindung betrifft einen Frequenzumrichter. Ein gattungsgemäßer Frequenzumrichter verfügt über ein Gehäuse, eine im Gehäuse angeordnete Platine zur Aufnahme leistungselektronischer Komponenten und eine außen am Gehäuse angeordnete Kopplungseinrichtung zur galvanischen Kopplung der Platine mit einem benachbart angeordneten zweiten Frequenzumrichter. Dabei weist die Kopplungseinrichtung entweder einen Basisabschnitt und ein gegenüber dem Basisabschnitt entlang eines definierten Bewegungspfades bewegliches Kopplungsglied auf oder ist als starre Stromschiene ausgebildet, die zur gleichzeitigen Anbringung am Frequenzumrichter und dem zweiten benachbart angeordneten Frequenzumrichter ausgebildet ist. Diese Kopplungseinrichtung ist galvanisch mit der Platine des Frequenzumrichters gekoppelt.

Gattungsgemäße Frequenzumrichter dienen der Umwandlung von Strom hinsichtlich seiner Frequenz, insbesondere zum Zwecke der Versorgung eines Drehstrommotors einer Maschine, beispielsweise von Robotern, Fertigungsmaschinen, Fördermaschinen oder dergleichen. Eine Mehrzahl von Verbrauchern, beispielsweise eine Mehrzahl von Drehstrommotoren, macht es häufig erforderlich, mehr als einen Frequenzumrichter gattungsgemäßer Art zu verwenden. Hierzu ist es bekannt, zwischen diesen mehreren Frequenzumrichtern eine Strom leitende galvanische Kopplung herzustellen, beispielsweise um einen gemeinsamen Zwischenkreis zu schaffen. Da im fraglichen Bereich der Frequenzumrichter mit hohen elektrischen Leistungen gearbeitet wird, ist es von höchster Wichtigkeit, dass die galvanische Kopplung mehrerer Frequenzumrichter miteinander in zuverlässiger Weise erfolgt.

Aus dem Stand der Technik sind hierzu verschiedene Systeme bekannt. So ist es beispielsweise bekannt, starre metallische Stromschienen zu nutzen, die außenseitig an Frequenzumrichtern angebracht werden und diese mechanisch und galvanisch koppeln. Aus der DE 102 30 393 A1 ist es ebenfalls bekannt, eine Kopplungseinrichtung der bereits genannten Art mit einem metallischen Basisabschnitt und einem gegenüber dem Basisabschnitt entlang eines definierten Bewegungspfades schwenkbeweglichen Kopplungsglied zu verwenden. Die DE 102 30 393 A1 beschreibt Schwenkhebel, welche an einem Frequenzumrichter schwenkbar angebracht sind und derart verschwenkt werden können, dass sie mittels einer Befestigungsschraube eines benachbarten Frequenzumrichters fixiert werden können.

Problematisch ist an einer solchen starren Verbindung der Frequenzumrichter miteinander, dass die genannten Kopplungseinrichtungen anders als flexible Verbindungskabel in genau definierter Position und Ausrichtung am Frequenzumrichter angebracht werden, wobei diese Ausrichtung von der Anbindung der Kopplungseinrichtung an zwei oder mehr einander benachbarten Frequenzumrichtern abhängt. Da die genau Lage und Ausrichtung der einzelnen Kopplungseinrichtung auch von deren Anbindung an einen benachbarten Frequenzumrichter abhängt, kann ein starres Verbindungsglied, welches zwischen der Kopplungseinrichtung und der Platine vorgesehen ist, eine dauerhafte Kraftbeaufschlagung der Platine des Frequenzumrichters bewirken. Eine solche permanente Krafteinwirkung auf eine Platine kann jedoch zu einem kritischen Versagen der Platine oder der galvanischen Kopplung zwischen Kopplungseinrichtung und Platine, beispielsweise durch Bruch der dort verwendeten Lötverbindung, führen. Aufgrund der hohen elektrischen Leistung, die zu übertragen ist, kann beispielsweise ein Leiterbahnenbruch auf einer Platine zu einer unmittelbaren und vollständigen Zerstörung des Frequenzumrichters und möglicherweise auch benachbarter Frequenzumrichter führen. Auch Fertigungstoleranzen an einem Frequenzumrichter selbst können dazu führen, dass eines starre Verbindung zwischen dessen Kopplungseinrichtung und seiner Platine zu einer kritischen Kraftbeaufschlagung der Platine führen kann.

Die galvanische Kopplung, die zwischen der Kopplungseinrichtung und den jeweiligen Platinen der Frequenzumrichter geschaffen wird, könnte alternativ mittels im Gehäuse des Frequenzumrichters angeordneter Verbindungskabel erfolgen, wobei dies in der Praxis zu einem erhöhten Montageaufwand führt.

Die US 2011/0164350 A1 zeigt eine Kontrolleinheit mit einem Gehäuse und einer außen am Gehäuse angeordneten Kopplungseinrichtung zur galvanischen Kopplung mit einer benachbart angeordneten zweiten Kontrolleinheit. Die Kopplungseinrichtung weist einen Basisabschnitt und ein gegenüber dem Basisabschnitt entlang eines definierten Bewegungspfads bewegliches Kopplungsglied auf. Die Kopplungseinrichtung ist mit in dem Gehäuse vorhandenen Elementen mittels eines Federelements verbunden, wobei dieses Federelement einen inneren elementseitigen Befestigungsabschnitt und einen kopplungseinrichtungsseitigen Befestigungsabschnitt aufweist, die durch den elastischen Federabschnitt miteinander verbunden sind.

Die WO 93/13587 A1 zeigt einen Frequenzumrichter, bei dem federnde Metallbänder zum Anschluss elektrischer Komponenten an zugehörige Schienen verwendet werden, um empfindliche Komponenten mechanisch von den auf die Schienen wirkenden Kräften zu entkoppeln.

Die DE 40 23 914 A1 zeigt einen Klemmenblock zum elektrischen Anschluss von Steuermodulen an Zwischenkreis-Sammelschienen.

### Aufgabe und Lösung

Aufgabe der Erfindung ist es, einen gattungsgemäßen Frequenzumrichter dahingehend weiterzubilden, dass trotz der starren Koppelbarkeit des Frequenzumrichters an einen oder mehrerer benachbarter Frequenzumrichter die Gefahr gemindert wird, dass es zu hohen Krafteinwirkungen auf die Platine kommt. Diese Weiterbildung sollte mit einer einfachen Montierbarkeit einhergehen.

Erfindungsgemäß wird diese Aufgabe dadurch gelöst, dass die Kopplungseinrichtung mit der Platine mittels eines Federelements verbunden ist, wobei dieses Federelement einen platinenseitigen Befestigungsabschnitt und einen kopplungseinrichtungsseitigen Befestigungsabschnitt aufweist, die durch einen elastischen Federabschnitt miteinander verbunden sind.

Erfindungsgemäß ist demnach vorgesehen, dass zwischen der Kopplungseinrichtung an der Außenseite des Gehäuses des Frequenzumrichters, deren tatsächliche Position und Ausrichtung auch von der Anordnung benachbarter Frequenzumrichter und von Fertigungstoleranzen hinsichtlich des Gehäuses abhängt, einerseits und der Platine des Frequenzumrichters andererseits das genannte Federelement vorgesehen ist, welches verhindert, dass Abweichungen der Position der Kopplungseinrichtung von einer vorgegebenen Soll-Position sich in einer zu starken Kraftbeaufschlagung der Platine oder von Lötstellen äußert. Dabei ist das Federelement vorzugsweise derart ausgebildet, dass eine Verlagerung der Kopplungseinrichtung gegenüber einer Soll-Position von 1 mm zu einer Kraftbeaufschlagung auf die Platine in entsprechender Richtung von nicht mehr als 1 Newton führt.

Anders als eine Kabelverbindung, die alternativ zu dem Federelement an gleicher Stelle vorgesehen werden könnte, gestattet es das erfindungsgemäß zu verwendende Federelement, ohne weitere gehäuseseitig vorzusehende Zwischenelemente bei geschlossenem Gehäuse die Kopplungseinrichtung am kopplungseinrichtungsseitigen Befestigungsabschnitt des Federelements zu befestigen, beispielsweise mit einer Schraube. Das Federelement ist hierfür ausreichend starr, so dass sich der kopplungseinrichtungsseitige Befestigungsabschnitt des Federelements nach Schließen des Gehäuses in einen Bereich unmittelbar hinter der Wandung des Gehäuses befindet. Dies gestattet es, nach Schließen des Gehäuses von außen die Kopplungseinrichtung mit dem zumindest in etwa in definierter Position angeordneten kopplungseinrichtungsseitigen Befestigungsabschnitt zu verbinden. Da somit das Erfordernis entfällt, die Platine zunächst mit einem gehäuseseitigfesten Zwischenelement zu verbinden, kann die Montage sehr einfach vonstatten gehen. Die Platine wird in das Gehäuse eingeschoben bzw. das Gehäuse auf die Platine aufgeschoben. Das zu diesem Zeitpunkt mit der Platine bereits verbundene Federelement wird dabei gemeinsam mit der Platine in das Gehäuse eingeschoben und nimmt in der Endlage der Platine bereits die zumindest in etwa reproduzierbare Soll-Position ein. Diese Soll-Position ist derartig gewählt, dass anschließend die Kopplungseinrichtung von außen vorzugsweise unmittelbar mit dem Befestigungsabschnitt des Federelements verbunden werden kann.

Bei dem Federelement selbst kann es sich um ein einfaches Bauteil aus einem Metallblech handeln, welches einfach oder mehrfach umgebogen ist, um die Strecke zwischen der Platine und der Soll-Position des kopplungseinrichtungsseitigen Befestigungsabschnitts in flexibler Weise zu überbrücken. Als eine besonders vorteilhafte Gestaltung hat sich eine Gestaltung des Federelements herausgestellt, bei der dieses aus einem gebogenen Blech hergestellt ist und mindestens zwei zueinander parallele Soll-Biegelinien aufweist, entlang derer Blechabschnitte beidseitig der jeweiligen Soll-Biegelinie gegeneinander begrenzt schwenkbeweglich sind. Durch die Gestaltung mit zwei zueinander parallelen Soll-Biegelinien wird eine mindest dreigliedrige Gestaltung der Blechabschnitte erzielt, die beispielsweise eine Parallelverlagerung eines endseitigen Blechabschnitts gegenüber dem anderen endseitigen Blechabschnitt gestattet. Als noch besser wird eine Gestaltung mit drei zueinander parallelen Soll-Biegelinien angesehen. Hiermit ist eine viergliedrige Gestaltung zu erzielen, bei der zwei Zwischenabschnitte zwischen den platinenseitigen und dem kopplungseinrichtungsseitigen Befestigungsabschnitt vorgesehen sind. Bei einer solchen Gestaltung ist in rein geometrischer Hinsicht durch die Soll-Biegelinien eine unbeschränkte Beweglichkeit der Befestigungsabschnitte gegeneinander gegeben. Dadurch wird es auch möglich, dass die Befestigungsabschnitte in einer zur Erstreckung der Soll-Biegelinien senkrechten Ebene gegeneinander vergleichsweise frei translativ beweglich sind. Die Bewegung der Befestigungsabschnitte gegeneinander in einer ersten Richtung führen aufgrund der Viergliedrigkeit nicht zur geometrisch bedingten Erzwingung einer Bewegung orthogonal zur ersten Richtung.

Die Soll-Biegelinien werden vorzugsweise durch bereits beim unbelasteten Grundkörper des Federelements vorgesehene Biegelinien gebildet, die naturgemäß gegen ein Verschwenken weniger Widerstand leisten als ein flächiger Blechabschnitt.

Der kopplungseinrichtungsseitige Befestigungsabschnitt und/oder der platinenseitige Befestigungsabschnitt des Federelements sind vorzugsweise einstückiger Teil des gleichen gebogenen Blechs, welches auch den Federabschnitt bildet. Grundsätzlich ist es jedoch auch möglich, separate Befestigungsabschnitte zu verwenden, die beispielsweise mittels einer Lötverbindung mit dem Federelement verbunden sind.

Zur Verbindung der Kopplungseinrichtung und des kopplungseinrichtungsseitigen Befestigungsabschnitts miteinander ist vorzugsweise eine Schraubverbindung vorgesehen. Der kopplungseinrichtungsseitige Befestigungsabschnitt weist daher vorzugsweise eine Gewindebohrung auf oder verfügt über eine drehfest angebrachte Mutter mit Gewindebohrung. Eine Schraube gestattet es dann, die Kopplungseinrichtung flächig an eine korrespondierende Fläche des Befestigungsabschnitts anzupressen und damit eine sehr widerstandsarme elektrische Verbindung zu schaffen.

Zwar ist es grundsätzlich auch denkbar, die Schraube selbst als einzige galvanische Verbindung zwischen dem Befestigungsabschnitt und der Kopplungseinrichtung zu nutzen. Bevorzugt ist allerdings das genannte flächige Anpressen der Kopplungseinrichtung und des Befestigungsabschnitts aneinander. Da der Befestigungsabschnitt jedoch im Gehäuse vorgesehen ist und die Kopplungseinrichtung an einer Außenseite des Gehäuses, ist vorzugsweise weiterhin vorgesehen, dass das Gehäuse im Bereich der Kopplungseinrichtung eine Durchbrechung aufweist, durch die hindurch der kopplungseinrichtungsseitige Befestigungsabschnitt und die Kopplungseinrichtung miteinander und vorzugsweise unmittelbar miteinander verbunden sind.

Hierbei ist vorzugsweise vorgesehen, dass diese Durchbrechung derart an den kopplungseinrichtungsseitigen Befestigungsabschnitt und die Kopplungseinrichtung angepasst ist, dass der kopplungseinrichtungsseitige Befestigungsabschnitt und die Kopplungseinrichtung sich gegenseitig in ihrer jeweiligen Position lagesichern. Unter einer solchen Lagesicherung ist zu verstehen, dass sowohl die Kopplungseinrichtung außerhalb des Gehäuses als auch der Befestigungsabschnitt innerhalb des Gehäuses die Größe der Durchbrechung zumindest abschnittsweise überragen, so dass nach Befestigung des Kopplungseinrichtung und des Befestigungsabschnitts aneinander dieser Verbund weder weiter in das Gehäuse hineingedrückt werden kann, noch nach außen aus dem Gehäuse herausgezogen werden kann.

Die Kopplungseinrichtung ist vorzugsweise in einer Ausnehmung auf der Außenseite des Gehäuses angeordnet, die zumindest grob die Position der Kopplungseinrichtung vorgibt. Dabei sollte diese Ausnehmung jedoch ausreichend Spiel aufweisen, um die Koppelung der Kopplungseinrichtung mit benachbarten und möglicherweise nicht genau positionierten Frequenzumrichtern zu gestatten.

Die Verbindung der Kopplungseinrichtung erfolgt dabei vorzugsweise ausschließlich an dem kopplungseinrichtungsseitigen Befestigungsabschnitt in einer nur mittels eines Werkzeugs zu lösenden Art. Eine unmittelbare Verschraubung der Kopplungseinrichtung am Gehäuse ist verzichtbar. Sobald die Kopplungseinrichtung durch Lösen der Schraube oder eines anderen Befestigungsmittels vom kopplungseinrichtungsseitigen Befestigungsabschnitt gelöst ist, ist auch die Trennbarkeit der Kopplungseinrichtung vom Gehäuse gegeben.

Als vorteilhaft wird es weiterhin angesehen, wenn am Gehäuse und am kopplungsseitigen Befestigungsabschnitt und/oder am Gehäuse und an der Kopplungseinrichtung Ausrichtungsmittel vorgesehen sind, insbesondere eine Ausrichtungsausnehmung einerseits und ein Ausrichtungsdorn andererseits. Da eine feste mittels eines Werkzeugs oder beispielsweise einer Rastverbindung geschaffene Verbindung zwischen der Kopplungseinrichtung und dem Gehäuse und/oder zwischen dem kopplungseinrichtungsseitigen Befestigungsabschnitt und dem Gehäuse vorzugsweise nicht gegeben ist, sind entsprechende Ausrichtungsmittel von Vorteil. Diese Ausrichtungsmittel bewirken im Falle des kopplungseinrichtungsseitigen Befestigungsabschnitts, dass dieser durch das Aufschieben des Gehäuses auf die Platine bereits recht präzise die Soll-Position einnimmt, die anschließend das Festschrauben der Kopplungseinrichtung von außen gestattet. Im Falle der Kopplungseinrichtung selbst sind entsprechende Ausrichtungsmittel von geringerer Relevanz, können jedoch auch von Vorteil sein, da hierdurch von dem Festschrauben der Kopplungseinrichtung am kopplungseinrichtungsseitigen Befestigungsabschnitt bereits eine weitgehend stimmige Relativpositionierung erzielbar ist.

Ausrichtmittel zur Ausrichtung des Federelements gegenüber dem Gehäuse können gleichzeitig als Momentenstütze dienen. Sie verhindern, dass das Federelement in seiner Gesamtheit beim Anziehen einer Befestigungsschraube zur Befestigung der Kopplungseinrichtung verdreht wird.

Grundsätzlich ist die Gestaltung des erfindungsgemäßen Frequenzumrichters unabhängig davon sinnvoll, welches Potential hierdurch gemeinsam von zwei oder mehr Frequenzumrichtern genutzt wird. Allerdings wird es als besonders vorteilhaft angesehen, wenn die Kopplungseinrichtung mit einem Zwischenkreispotential des Frequenzumrichters galvanisch gekoppelt ist. Weiterhin von Vorteil ist es, wenn zwei derartige Kopplungseinrichtungen vorgesehen sind, die mittels jeweils eines eigenen Federelements mit der Hauptplatine verbunden sind. Somit ist eine gemeinsame Zwischenkreisspannung für mehrere Frequenzumrichter zu verwenden.

### Kurzbeschreibung der Zeichnungen

Weitere Aspekte und Vorteile der Erfindung ergeben sich außer aus den Ansprüchen auch aus der nachfolgenden Beschreibung eines bevorzugten Ausführungsbeispiels der Erfindung, welches anhand der Figuren nachfolgend erläutert wird. Dabei zeigen:
- Fig. 1a und 1b: eine Anordnung mit drei erfindungsgemäßen Frequenzumrichtern, deren Zwischenkreis miteinander galvanisch gekoppelt ist,
- Figur 2: einen dieser Frequenzumrichter in einer Explosionsdarstellung, aus der die im Zusammenhang mit dieser Erfindung wesentlichen Komponenten isoliert hervor gehen,
- Figur 3: einen Teilbereich der Hauptplatine des Frequenzumrichters mit daran angebrachten Federelementen,
- Figur 4: den Teilbereich der Figur 3 in einer geschnittenen Darstellung,
- Figur 5: ein Federelement des zuvor gezeigten Frequenzumrichters in einer Detaildarstellung und
- Fig. 6a bis 6c: die Beweglichkeit von beiderseits am Federelement vorgesehenen Befestigungsabschnitten gegeneinander.

### Detaillierte Beschreibung des Ausführungsbeispiels

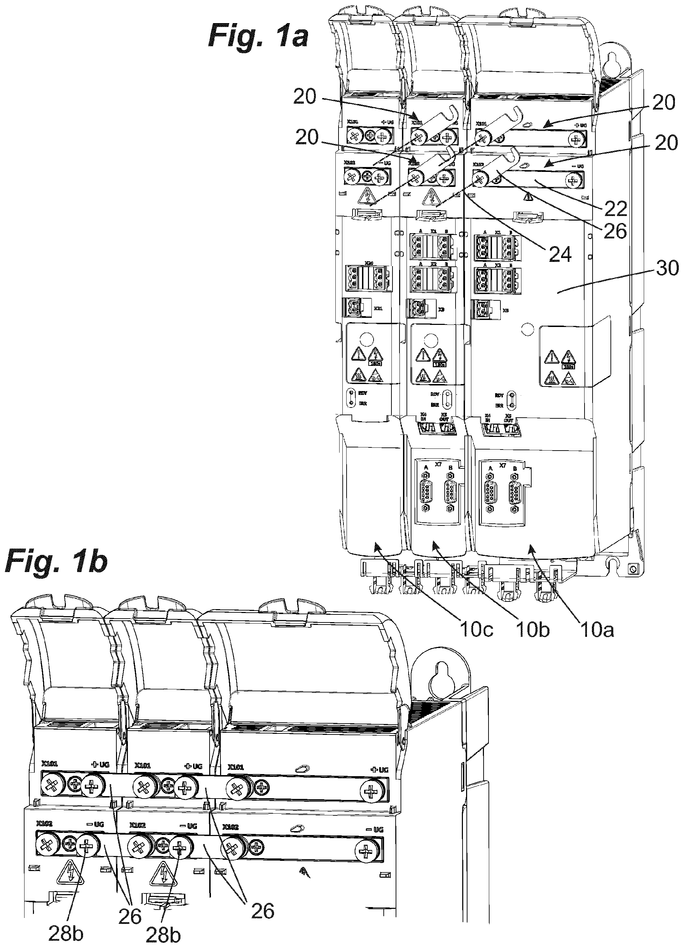

Die Figuren 1 a und 1 b zeigen eine Anordnung mit drei Frequenzumrichtern 10a, 10b, 10c. Diese Frequenzumrichter werden in dem dargestellten Verbund verwendet, um beispielsweise für verschiedene Freiheitsgrade eines Aktors einer Maschine verwendete Drehstrommotoren zu steuern.

Die für sich genommen auch jeweils alleine funktionstauglichen Frequenzumrichter 10a, 10b, 10c sind im Hinblick auf ihren Zwischenkreis miteinander galvanisch gekoppelt. Hierzu weisen sie Kopplungseinrichtungen 20 auf, die jeweils paarweise an einer Außenseite der Frequenzumrichter vorgesehen sind. Die Kopplungseinrichtungen 20 umfassen jeweils eine metallischen Basisabschnitt 22 zur im Wesentlichen ortsfesten Anbringung an einer Außenseite des jeweiligen Gehäuses 30 des Frequenzumrichters sowie im Falle der Frequenzumrichter 10a, 10b einen gegenüber diesem Basisabschnitt 22 um eine Achse 24 verschwenkbaren ebenfalls metallischen Kopplungsabschnitt 26. In der in Figur 1b erkennbaren Weise sind diese Kopplungsabschnitte 26 dafür vorgesehen, in den Bereich des Basisabschnitts 20 des benachbarten Frequenzumrichters 10b, 10c geschwenkt zu werden, um dort mittels einer Befestigungsschraube 28b fixiert zu werden.

Um einen problemlosen und möglichst widerstandsarmen Stromfluss zu gewährleisten, sind die schwenkbaren Kopplungsabschnitte 26 am jeweiligen Basisabschnitt 22 soweit als möglich spielfrei geführt. Aus demselben Grund wird auch die Schraube 28 bestimmungsgemäß fest angezogen, um eine widerstandsarme flächige Verbindung zwischen beispielsweise dem Kopplungsabschnitt 26 des Frequenzumrichters 10a und dem Basisabschnitt 22 des benachbarten Frequenzumrichters 10b zu gewährleisten. Nachteil dieser starren Verbindung ist, dass die jeweiligen Basisabschnitte 22 der oberen bzw. der unteren Reihe der Kopplungseinrichtungen 20 zueinander starr ortsfest sind und somit beispielsweise aufgrund nicht ganz genauer Positionierung der jeweiligen Frequenzumrichter 10a, 20b, 10c als Ganzes relativ zu der in den Frequenzumrichtern vorgesehenen Platine 12a eine im geringen, jedoch entscheidendem Maße, variable Position einnehmen. Auch Fertigungstoleranzen an einem Frequenzumrichter können zu einer Variabilität der Kopplungseinrichtung 20 gegenüber der Platine 12a führen.

Wenn in solchen Fällten entgegen der Erfindung eine vollständig starre Verbindung zwischen den jeweiligen Basisabschnitten 22 und den jeweiligen Platinen innerhalb der Gehäuse 30 der Frequenzumrichter 10a, 10b, 10c geschaffen würde, so würde die schwer zu vermeidende Ungenauigkeit hinsichtlich der genauer Anordnung und Ausrichtung der Basisabschnitte 22 dazu führen, dass es zu einer hohen Krafteinleitung in die Platine kommt. Ein Versagen von Lötstellen oder von Leiterbahnen mit schwerwiegenden Folgen wäre zu befürchten.

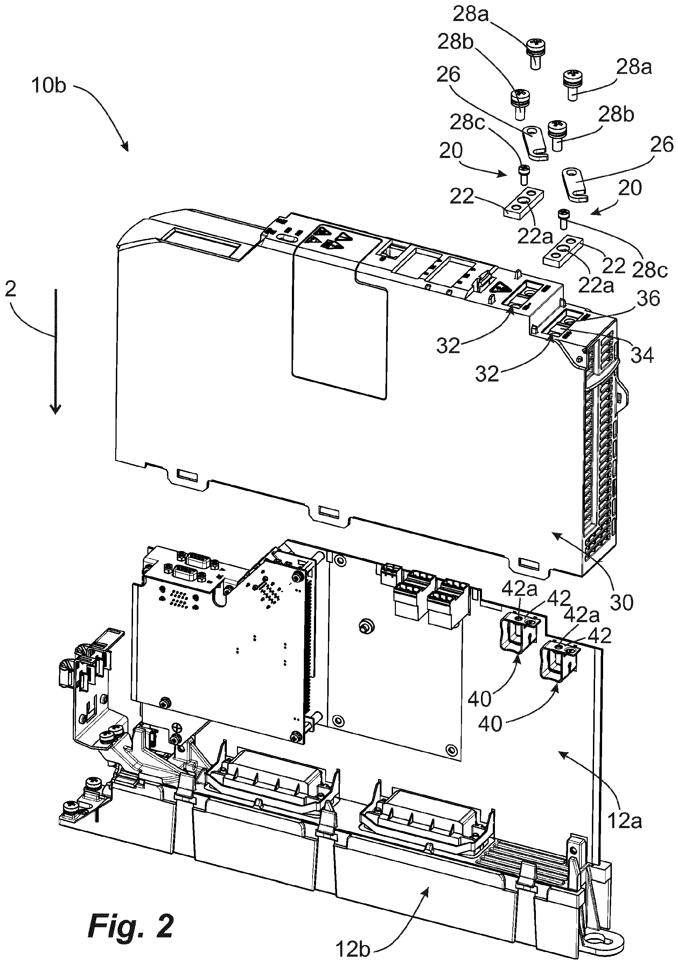

Figur 2 verdeutlicht den grundsätzlichen Aufbau eines erfindungsgemäßen Frequenzumrichters, der dieses Problem löst. Figur 2 stellt dabei eine Explosionsdarstellung dar. Die hier dargestellten Komponenten umfassen eine Hauptplatine 12a mit daran befestigtem Kühlkörper 12b, der gleichzeitig auch der Anbringung des Frequenzumrichters 10b an einer Wandung eines Schaltschrankes dient. Auf die Platine aufschiebbar ist ein schalenartiges Gehäuse 30 aus Kunststoff. Zur Aufnahme der Basisabschnitte 22 der Kopplungseinrichtungen 20 sind an der Außenseite dieses Gehäuses Ausnehmungen 32 vorgesehen.

Zur Kontaktierung mit den jeweiligen Basisabschnitten 22 sind fest mit der Platine verlötet zwei Federelemente 40 vorgesehen, deren Anordnung korrespondierend zur Anordnung der Ausnehmungen 32 vorgesehen ist. Diese Federelemente sind auf der Platine galvanisch mit jeweils einem Zwischenkreisleiter verbunden.

Die bestimmungsgemäße Montage sieht nun vor, dass das Gehäuse 30 in Richtung des Pfeils 2 auf die Platine 12a aufgeschoben wird. Hierdurch gelangen die Federelemente 40 in eine Position unmittelbar unterhalb der Ausnehmungen 32. Eine vollständige Festlegung des jeweiligen am distalen Ende des jeweiligen Federelements 40 vorgesehenen Befestigungsabschnitts 42 am Gehäuse 12 ist nicht vorgesehen. Lediglich Ausrichtungsmittel sind auf Seiten des Befestigungsabschnitts und auf Seiten des Gehäuses vorgesehen, um die richtige Positionierung der kopplungseinrichtungsseitigen Befestigungsabschnitte 42 der Federelemente 40 zu gewährleisten und um als Momentenstütze zu dienen. Dies wird im Weiteren noch erläutert.

Nach dem Aufschieben des Gehäuses 30 auf die Platine 12a und die dadurch bewirkte Anordnung der kopplungseinrichtungsseitigen Befestigungsabschnitte 42 in etwa in ihrer Sollposition, erfolgt die Anbringung der Kopplungseinrichtungen 20. Deren Basisabschnitte 22 werden in die Aussparungen 32 eingelegt. Anschließend wird durch eine Durchgangsbohrung 22a in den Basisabschnitten 22 hindurch jeweils eine Schraube 28c in eine Gewindebohrung 42a des jeweiligen Federelements 40 eingeschraubt.

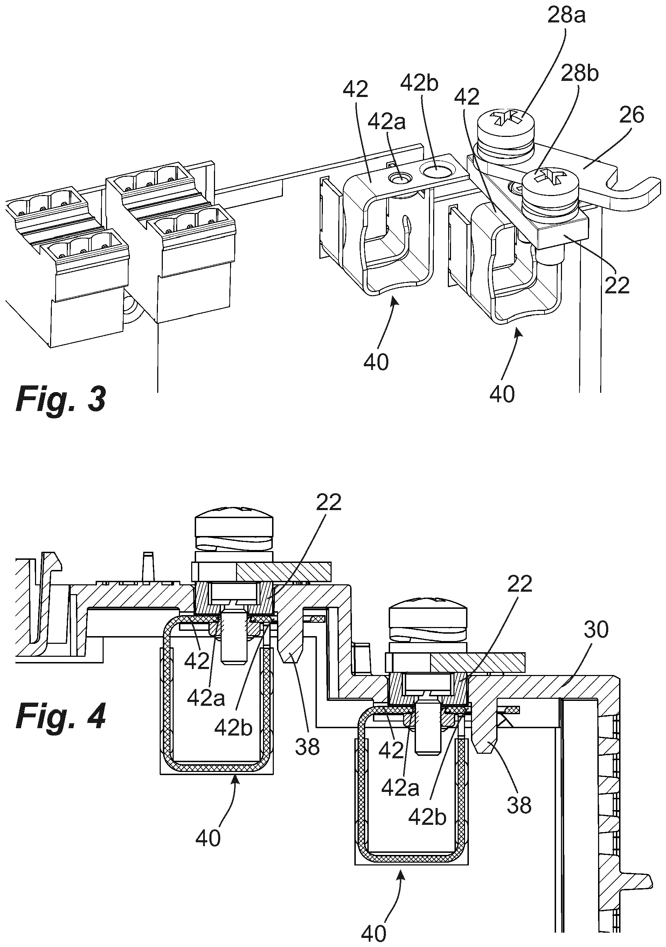

Unter Ausblendung des Gehäuses 30 ergibt sich dadurch eine Anordnung, wie sie durch Figur 3 verdeutlicht wird. Der kopplungseinrichtungsseitige Befestigungsabschnitt 42 der Federelemente 40 liegt dabei flächig am Basisabschnitt 22 der Kopplungseinrichtungen 20 an. Hierdurch ist ein widerstandsarmer Stromfluss möglich. Die beiden Schrauben 28a, 28b, von denen die erste Schraube 28a der schwenkbaren Anlenkung des Kopplungsabschnitts 26 dient und von denen die zweite Schraube 28b der Festlegung des Kopplungsabschnitts 26 des benachbarten Frequenzumrichters dient, erstrecken sich durch den Basisabschnitt 22 hindurch. Ihr freies Ende greift in in Figur 3 nicht dargestellte gewindelose Ausnehmungen 36 des Gehäuses 30 ein, so dass hierdurch Ausrichtmittel zur Verfügung gestellt werden.

Die Lagesicherung des Basisabschnitts 22 und des kopplungseinrichtungsseitigen Befestigungsabschnitts 42 erfolgt durch deren Anbringung aneinander. Eine jeweilige Durchbrechung 34 am Grund der jeweiligen Ausnehmung 32, durch die hindurch das Federelement 40 und der Basisabschnitt 22 miteinander verbunden sind, weist eine Größe und/oder Formgebung auf, die weder ein ungewollt weites Eindringen des Basisabschnitts 22 in das Gehäuse noch ein Herausziehen des Befestigungsabschnitts 42 aus dem Gehäuse herausgestattet. Sowohl der Befestigungsabschnitt 42 als auch der Basisabschnitt 22 überragen die Durchbrechung 34 zumindest partiell.

Diese Form der Lagefixierung wird im Hinblick auf den Befestigungsabschnitt 42 auch anhand der Schnittdarstellung der Figur 4 deutlich. Die Durchbrechung 34 ist allerdings ausreichend groß, um einen direkten Flächenkontakt zwischen dem Befestigungsabschnitt 42 und dem Basisabschnitt 22 zu gewährleisten.

Aus Figur 4, die den Teilbereich der Figur 3 in einer geschnittenen Darstellung zeigt, ist weiterhin ersichtlich, dass die Ausrichtungsmittel zur Positionierung des Federelements 40 relativ zum Gehäuse 30 einen Ausrichtungsdorn 38 an der Innenseite des Gehäuses und eine korrespondierende Ausrichtungsbohrung 42b am Federelement umfassen. Bei der Annäherung des Gehäuses 30 an das Federelement 40 kommt es auch aufgrund dieser Ausrichtungsmittel 38, 42b zur gewünschten Ausrichtung, die anschließend das Einschrauben der Schrauben 28c zur Festlegung des jeweiligen Basisabschnitts 22 gestattet. Auch ist aus Figur 4 ersichtlich, dass der am Gehäuse anliegende Befestigungsabschnitt 42 des Federelements 40 eine Größe hat, die ein Herausziehen aus dem Gehäuse gemeinsam mit dem Basisabschnitt 22 nicht gestattet.

Wenn der Ausrichtdorn 38 in der Ausrichtbohrung 42b angeordnet ist, dient er gleichzeitig auch als Momentenstütze, die verhindert, dass durch ein Verdrehen des Federelements 40 während des Festziehens der Schraube 28c zu hohe Kräfte auf die Lötanbindung des Federelements 40 an die Platine 12a wirken.

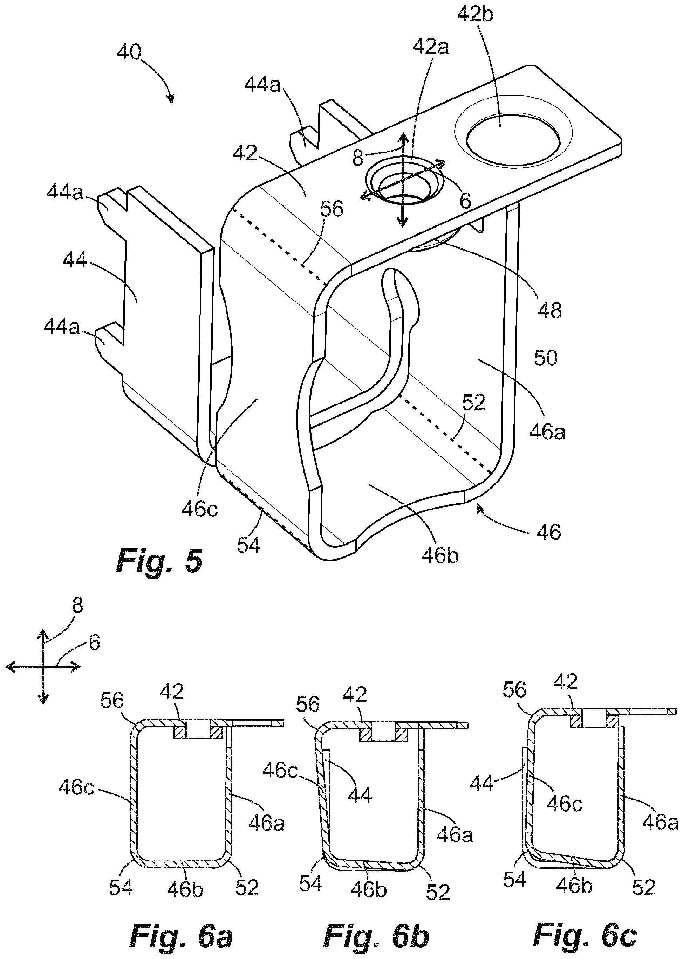

Figur 5 zeigt in separater Darstellung ein bei dem erfindungsgemäßen Frequenzumrichter verwendetes Federelement 40. Dieses weist einen U-förmigen platinenseitigen Befestigungsabschnitt 44 auf, der im Bereich von vier Lötabschnitten 44a auf der Platine 12a festgelötet wird. Die nicht fluchtende Anordnung der Lötabschnitt 44a führt zu einer stabilen Festlegung des Befestigungsabschnitts 44 an der Platine 12a. Die Einleitung einer Kraft am anderen Ende des Federelements, dem kopplungseinrichtungsseitigen Befestigungsabschnitt 42, führt zu keiner nennenswerte Krafteinleitung in die in Fig. 5 linksseitigen Lötabschnitte 44a, so dass die Verbindung zwischen dem Federelement 40 und der Platine auch unter widrigen Umständen erhalten bleibt.

Am zum platinenseitigen Befestigungsabschnitt 44 gegenüberliegenden Ende verfügt das Federelement 40 über den bereits genannten kopplungseinrichtungsseitigen Befestigungsabschnitt 42. Dieser weist in der bereits beschrienen Art eine Gewindebohrung 42a und eine Ausrichtbohrung 42b auf. Die Gewindebohrung könnte ein direkt in das Blech des Federelements 40 eingebrachtes Gewinde aufweisen. Vorliegend ist jedoch stattdessen vorgesehen, dass eine Mutter 48 mit Innengewinde drehgesichert am Befestigungsabschnitt 42 befestigt ist. Der kopplungseinrichtungsseitigen Befestigungsabschnitt 42 ist nach Anbringung des zugeordneten Basisabschnitts 22 gegenüber diesem nicht mehr beweglich.

Zwischen den beiden Befestigungsabschnitten 42, 44 ist der eigentliche Federabschnitt 46 vorgesehen, der eine variable Relativpositionierung der Befestigungsabschnitte 42, 44 zueinander ermöglicht, ohne dass es zu einer starken Krafteinleitung in die Platine 12a kommt. Der Federabschnitt ist demnach so ausgebildet / angebunden, dass er bei nur geringer Krafteinleitung eine Verlagerung des Befestigungsabschnitts 42 gegenüber dem Befestigungsabschnitts 44 gestattet, ohne dass es hierdurch zu einer starken Krafteinleitung in die Lötverbindung am Befestigungsabschnitt 44 und/oder in die Platine 12a selbst kommt.

Der Federabschnitt weist zu diesem Zweck einen ersten Blechabschnitt 46a auf, der weitgehend unbeweglich gegenüber dem platinenseitigen Befestigungsabschnitt 44 ist. Dieser ist mittels zweier sich kettenartig aneinander anschließender Blechabschnitte 46b, 46c mit dem kopplungseinrichtungsseitigen Befestigungsabschnitt 42 verbunden. Zwischen den Abschnitten 46a, 46b, 46c, 42 ist das Blech entlang von Biegelinien 52, 54, 56 jeweils um etwa 90° gebogen. Diese Biegelinien gestatten eine Bewegung der Befestigungsabschnitte 42, 44 gegeneinander.

Anhand der Figuren 6a bis 6c ist die Beweglichkeit verdeutlicht. Figur 6a stellt den unbelasteten Zustand des Federelements 40 dar. Figur 6b verdeutlicht, dass aufgrund der beiden Blechabschnitte 46b, 46c und der drei Biegelinien 52, 54, 56 eine rein translative horizontale Verlagerung des Befestigungsabschnitts 42 geometrisch möglich ist. Figur 6c zeigt, dass auch eine Verlagerung in Hochrichtung und eine translative Verlagerung gleichzeitig möglich sind. Aufgrund der drei Biegelinien 52, 54, 56 und der beiden Blechabschnitte 46b, 46c zwischen den Befestigungsabschnitten 42, 44 sind diese horizontale und vertikale Verlagerung geometrisch unabhängig voneinander. In der Ebene der Pfeile 6 und 8 kann das Federelement 40 daher Toleranzen hinsichtlich der Relativanordnung der Kopplungseinrichtung 20 zur Platine 12a gut ausgleichen. In gewissen Grenzen ist durch ein Tordieren des Federabschnitts 46 auch ein Toleranzausgleich quer hierzu möglich.

Das Federelement ist derart geformt, dass der Blechabschnitt 46a auch als Stütze für den Befestigungsabschnitt 42 dient. Dieser kann beim Festschrauben der Kopplungseinrichtung 20 daher nur begrenzt nach unten ausweichen.

## Patentansprüche

1. Frequenzumrichter (10a, 10b, 10c) mit
- einem Gehäuse (30),
- einer im Gehäuse angeordneten Platine (12a) und
- einer außen am Gehäuse (30) angeordnete Kopplungseinrichtung (20) zur galvanischen Kopplung der Platine (12a) mit einem benachbart angeordneten zweiten Frequenzumrichter (10b, 10c),
wobei
- die Kopplungseinrichtung (20) entweder
- einen Basisabschnitt (22) und ein gegenüber dem Basisabschnitt (22) entlang eines definierten Bewegungspfades bewegliches Kopplungsglied (26) aufweist oder
- als starre Stromschiene ausgebildet ist, die zur gleichzeitigen Anbringung am Frequenzumrichter und dem zweiten Frequenzumrichter ausgebildet ist,
- die Kopplungseinrichtung (22) galvanisch mit der Platine (12a) gekoppelt ist, und
- die Kopplungseinrichtung (22) mit der Platine (12a) mittels eines Federelements (40) verbunden ist, wobei dieses Federelement (40) ein platinenseitigen Befestigungsabschnitt (44) und einen kopplungseinrichtungsseitigen Befestigungsabschnitt (42) aufweist, die durch einen elastischen Federabschnitt (46) miteinander verbunden sind,
wobei
- das Federelement (40) mit der Platine (12a) mittels einer Lötverbindung verbunden ist.

2. Frequenzumrichter nach Anspruch 1,
**dadurch gekennzeichnet, dass**
das Federelement (40) aus einem gebogenen Blech hergestellt ist und mindestens zwei zueinander parallele Soll-Biegelinien (52, 54, 56) aufweist, entlang derer Blechabschnitte (46a, 46b, 46c, 42) beidseitig der jeweiligen Soll-Biegelinie gegeneinander begrenzt beweglich sind.

3. Frequenzumrichter nach Anspruch 1 oder 2,
**dadurch gekennzeichnet, dass**
die Kopplungseinrichtung (20) und der kopplungseinrichtungsseitige Befestigungsabschnitt (42) miteinander über eine Schraubverbindung (28) verbunden sind.

4. Frequenzumrichter nach einem der vorstehenden Ansprüche,
**dadurch gekennzeichnet, dass**
das Gehäuse (30) im Bereich der Kopplungseinrichtung (20) eine Durchbrechung (34) aufweist, durch die hindurch der kopplungseinrichtungsseitige Befestigungsabschnitt (42) und die Kopplungseinrichtung (20) miteinander verbunden sind, wobei die Durchbrechung (34) vorzugsweise derart an den kopplungseinrichtungsseitigen Befestigungsabschnitt (42) und die Kopplungseinrichtung (20) angepasst ist, dass der kopplungseinrichtungsseitige Befestigungsabschnitt (42) und die Kopplungseinrichtung (20) sich gegenseitig in ihrer jeweiligen Position lagesichern.

5. Frequenzumrichter nach einem der vorstehenden Ansprüche,
**dadurch gekennzeichnet, dass**
das Gehäuse (30) an seiner Außenseite eine Ausnehmung (32) aufweist, in welcher die Kopplungseinrichtung (20) zumindest abschnittsweise angeordnet ist.

6. Frequenzumrichter nach einem der vorstehenden Ansprüchen,
**dadurch gekennzeichnet, dass**
die Kopplungseinrichtung (20) durch eine nur mittels eines Werkzeugs zu lösenden Festlegung lediglich mit dem kopplungseinrichtungsseitigen Befestigungsabschnitt (42) verbunden ist.

7. Frequenzumrichter nach einem der vorstehenden Ansprüche,
**dadurch gekennzeichnet, dass**
am Gehäuse (30) und am kopplungseinrichtungsseitigen Befestigungsabschnitt (42) und/oder am Gehäuse (30) und am Basisabschnitt (22) der Kopplungseinrichtung (20) Ausrichtungsmittel (28a, 28b, 38, 42b) vorgesehen sind, insbesondere eine Ausrichtungsausnehmung (42b) einerseits und ein Ausrichtungsdorn (38, 28a, 28b) andererseits.

8. Frequenzumrichter nach einem der vorstehenden Ansprüchen,
**dadurch gekennzeichnet, dass**
die Kopplungseinrichtung (20) mit einem Zwischenkreispotential eines Zwischenkreises des Frequenzumrichters (10a, 10b, 10c) galvanisch gekoppelt ist.

9. Frequenzumrichter nach einem der vorstehenden Ansprüchen,
**dadurch gekennzeichnet, dass**
zwei Kopplungseinrichtungen (20) vorgesehen sind, die mittels jeweils eines eigenen Federelements (40) mit der Platine (12a) verbunden sind.

## Claims

1. Frequency converter (10a, 10b, 10c), comprising
- a housing (30),
- a circuit board (12a) arranged in the housing, and
- a coupling arrangement (20) arranged externally on the housing (30) for galvanically coupling the circuit board (12a) to an adjacently arranged second frequency converter (10b, 10c),
wherein
- the coupling arrangement (20) either
- comprises a base portion (22) and a coupling member (26) movable with respect to the base portion (22) along a defined movement path, or
- is formed as a rigid busbar which is designed for simultaneous attachment to the frequency converter and the second frequency converter,
- the coupling arrangement (20) is galvanically coupled to the circuit board (12a), and
- the coupling arrangement (20) is connected to the circuit board (12a) by means of a spring element (40), wherein this spring element (40) comprises a fastening portion (44) on the circuit board side and a fastening portion (42) on the coupling arrangement side, said fastening portions being interconnected by a resilient spring portion (46),
wherein
- the spring element (40) is connected to the circuit board (12a) by means of a soldered connection.

2. Frequency converter according to claim 1, **characterized in that**
the spring element (40) is produced from a bent sheet metal and has at least two mutually parallel predetermined bending lines (52, 54, 56), along which sheet metal portions (46a, 46b, 46c, 42) can be moved in a limited manner with respect to one another on either side of the respective predetermined bending line.

3. Frequency converter according to claim 1 or 2, **characterized in that**
the coupling arrangement (20) and the fastening portion (42) arranged on the coupling arrangement side are interconnected via a screw connection (28).

4. Frequency converter according to any one of the preceding claims, **characterized in that**
the housing (30), in the region of the coupling arrangement (20), comprises an opening (34) through which the fastening portion (42) on the coupling arrangement side and the coupling arrangement (20) are interconnected, wherein the opening (34) is preferably adapted to the fastening portion (42) on the coupling arrangement side and to the coupling arrangement (20) in such a way that the fastening portion (42) on the coupling arrangement side and the coupling arrangement (20) secure one another in their respective positions.

5. Frequency converter according to any one of the preceding claims, **characterized in that**
the housing (30), on its outer face, has a recess (32) in which the coupling arrangement (20) is arranged at least in portions.

6. Frequency converter according to any one of the preceding claims, **characterized in that**
the coupling arrangement (20) is connected merely to the fastening portion (42) on the coupling arrangement side by a fixing that is to be detached only by means of a tool.

7. Frequency converter according to any one of the preceding claims, **characterized in that**
alignment means (28a, 28b, 38, 42b), in particular an alignment recess (42b) on the one hand and an alignment pin (38, 28a, 28b) on the other hand, are provided on the housing (30) and on the fastening portion (42) on the coupling arrangement side and/or on the housing (30) and on the base portion (22) of the coupling arrangement (20).

8. Frequency converter according to any one of the preceding claims, **characterized in that**
the coupling arrangement (20) is galvanically coupled to an intermediate circuit potential of an intermediate circuit of the frequency converter (10a, 10b, 10c).

9. Frequency converter according to any one of the preceding claims, **characterized in that**
two coupling arrangements (20) are provided, the coupling arrangements (20) being respectively connected by means of their own spring element (40) to the circuit board (12a).

## Revendications

1. Convertisseur de fréquence (10a, 10b, 10c), comprenant
- un boîtier (30),
- une platine (12a) disposée dans le boîtier et
- un dispositif de couplage (20) disposé à l'extérieur du boîtier (30) et servant au couplage galvanique de la platine (12a) avec un deuxième convertisseur de fréquence (10b, 10c) disposé à côté,
- le dispositif de couplage (20) :
- soit possédant une portion de base (22) et un élément de couplage (26) mobile par rapport à la portion de base (22) le long d'un trajet de déplacement défini ou
- soit étant réalisé sous la forme d'une barre-bus rigide qui est configurée pour être fixée simultanément au convertisseur de fréquence et au deuxième convertisseur de fréquence,
- le dispositif de couplage (22) étant couplé galvaniquement avec la platine (12a), et
- le dispositif de couplage (22) étant relié à la platine (12a) au moyen d'un élément ressort (40), cet élément ressort (40) possédant une portion de fixation côté platine (44) et une portion de fixation côté dispositif de couplage (42), lesquelles sont reliées l'une à l'autre par une portion de ressort élastique (46),
- l'élément ressort (40) étant relié à la platine (12a) au moyen d'une liaison brasée.

2. Convertisseur de fréquence selon la revendication 1, **caractérisé en ce que** l'élément ressort (40) est fabriqué à partir d'une tôle pliée et possède au moins deux lignes de pliage voulues (52, 54, 56) mutuellement parallèles, le long desquelles des portions de tôle (46a, 46b, 46c, 42) ont une mobilité limitée les unes par rapport aux autres des deux côtés de la ligne de pliage voulue correspondante.

3. Convertisseur de fréquence selon la revendication 1 ou 2, **caractérisé en ce que** le dispositif de couplage (20) et la portion de fixation côté dispositif de couplage (42) sont reliés l'un à l'autre par le biais d'une liaison vissée (28).

4. Convertisseur de fréquence selon l'une des revendications précédentes, **caractérisé en ce que** le boîtier (30) possède dans la zone du dispositif de couplage (20) une percée (34) à travers laquelle la portion de fixation côté dispositif de couplage (42) et le dispositif de couplage (20) sont reliés l'un à l'autre, la percée (34) étant de préférence adaptée à la portion de fixation côté dispositif de couplage (42) et au dispositif de couplage (20) de telle sorte que la portion de fixation côté dispositif de couplage (42) et le dispositif de couplage (20) se fixent mutuellement dans leur position respective.

5. Convertisseur de fréquence selon l'une des revendications précédentes, **caractérisé en ce que** le boîtier (30) possède sur son côté extérieur une cavité (32) dans laquelle le dispositif de couplage (20) est disposé au moins en partie.

6. Convertisseur de fréquence selon l'une des revendications précédentes, **caractérisé en ce que** le dispositif de couplage (20) est uniquement relié à la portion de fixation côté dispositif de couplage (42) par une fixation qui ne peut être libérée qu'au moyen d'un outil.

7. Convertisseur de fréquence selon l'une des revendications précédentes, **caractérisé en ce que** des moyens d'orientation (28a, 28b, 38, 42b) sont prévus sur le boîtier (30) et sur la portion de fixation côté dispositif de couplage (42) et/ou sur le boîtier (30) et sur la portion de base (22) du dispositif de couplage (20), notamment une cavité d'orientation (42b) d'un côté et une broche d'orientation (38, 28a, 28b) de l'autre côté.

8. Convertisseur de fréquence selon l'une des revendications précédentes, **caractérisé en ce que** le dispositif de couplage (20) est couplé galvaniquement à un potentiel de circuit intermédiaire d'un circuit intermédiaire du convertisseur de fréquence (10a, 10b, 10c).

9. Convertisseur de fréquence selon l'une des revendications précédentes, **caractérisé en ce que** deux dispositifs de couplage (20) sont prévus, lesquels sont reliés à la platine (12a) respectivement au moyen d'un élément ressort (40) propre.
